# EUROPÄISCHE PATENTSCHRIFT

(11) **EP 0 853 846 B1**
(45) Veröffentlichungstag und Bekanntmachung des Hinweises auf die Patenterteilung: **22.02.2006**
(21) Anmeldenummer: 97935484.2
(22) Anmeldetag: 25.07.1997
(51) Int. Cl.: H04H 1/00

(54) **RUNDFUNKEMPFÄNGER MIT DATENSPEICHER FÜR SENDEFREQUENZEN UND DIESEN ZUGEORDNETEN KENNZEICHNENDEN CODES**
RADIO RECEIVER WITH A MEMORY FOR TRANSMISSION FREQUENCIES AND CODES ASSOCIATED TO SAID FREQUENCIES
RECEPTEUR RADIO AVEC MEMOIRE POUR FREQUENCES D'EMISSION ET CODES AFFECTES A CES FREQUENCES

(30) Priorität: 30.07.1996 DE 19630578
(43) Veröffentlichungstag der Anmeldung: 22.07.1998
(73) Patentinhaber: ROBERT BOSCH GMBH, 70442 Stuttgart (DE)
(72) Erfinder: HEGELER, Wilhelm, D-31134 Hildesheim (DE)
(86) Internationale Anmeldenummer: PCT/DE1997/001573
(87) Internationale Veröffentlichungsnummer: WO 1998/005136

(56) Entgegenhaltungen:
- EP-A- 0 415 132
- EP-A- 0 602 438
- DE-A- 4 433 383
- GB-A- 2 240 679

## Beschreibung

### Stand der Technik

Die Erfindung geht von einem Rundfunkempfänger, insbesondere Autoradio, nach der Gattung des Hauptanspruchs aus.

Gemäß der "Specifications of the radio data system RDS for VHF/FM sound broadcasting" der European Broadcasting Union vom März 1984 werden auf den Sendefrequenzen der Rundfunksender neben dem eigentlichen Hörfunkprogramm auch digitale Daten, so auch die Sendefrequenzen kennzeichnende Codes, bestehend aus einer Länderkennung, einer Regionalkennung zur Kennzeichnung der räumlichen Verbreitung des über die Sendefrequenz ausgestrahlten Programmes und einer Sender- bzw. Programmkennung, übertragen. Dabei werden vor allem bei größeren Sendeanstalten Programme zeitweise regionalisiert. Zur Unterscheidung dieser verschiedenen Regionalprogramme werden ihnen bei gleicher Senderkennung verschiedene Regionalcodes zugeordnet, die zum Teil auch nach einer eventuellen Zusammenschaltung der Regionalprogramme zu einem überregionalen Programm erhalten bleiben. Man spricht hier von einer statischen Regionalisierung".

Aus der EP 0 305 172 B1 ist ein Rundfunkempfänger mit einem Speicher für Sendefrequenzen und die Sendefrequenzen kennzeichnende Codes bekannt, bei denen die Sendefrequenzen nach den Codes im Speicher abgelegt sind. Dabei sind verschiedenen Tasten des Autoradios vom Benutzer vorgebbare PI-Codes zugeordnet, so daß im jeweils einer Taste zugeordneten Speicher nur solche Sendefrequenzen abgespeichert werden, die maximal um ein vorgegebenes Maß von den jeweils vorgegebenen PI-Codes der Tasten abweichen.

GB2240679 und EP0415132 erwähnen in ihrer Einleitung einen sogenannten "Regionalschalter", der es erlaubt, den Regionalcode auszuwerten oder zu ignorieren.

GB2240679 betrifft das gezielte Wechseln von einem Regionalprogramm zu einem anderen Regionalprogramm innerhalb derselben Programmkette.

EP0415132 bevorzugt die alternativen Frequenzen eines anderen Regionalprogrammes der gleichen Programmkette, wenn bei einer Empfangsverschlechterung keine alternativen Frequenzen des aktuellen Regionalprogrammes verfügbar sind.

### Vorteile der Erfindung

Der erfindungsgemäße Rundfunkempfänger mit den Merkmalen des Hauptanspruchs ermöglicht auf einfache Weise die Auswahl der im Speicher abgelegten Sendefrequenzen anhand der ihnen zugeordneten Codes.

Gemäß einer Fortbildung der Erfindung ist es vorgesehen, nur die Sendefrequenzen aufzurufen, die am aktuellen Empfängerstandort auch tatsächlich empfangbar sind. Dies ist besonders dann von Vorteil, wenn die auf den aufgerufenen Sendefrequenzen übertragenen Programme kurzzeitig zu Gehör gebracht werden, da sich dann ein nicht oder nur schlecht zu empfangendes Programm unangenehm bemerkbar machen würde.

Als Erleichterung bei der Auswahl eines wiederzugebenden Rundfunkprogrammes ist es von Vorteil, wenn das mit der Blätterfunktion aufgerufene Programm kurzzeitig zu Gehör, oder/und der Name des Programms über ein Anzeigeinstrument angezeigt wird.

### Zeichnung

Ausführungsbeispiele der Erfindung sind in der Zeichnung dargestellt und werden im folgenden näher erläutert.

Es zeigen Figur 1 ein Ausführungsbeispiel des erfindungsgemäßen Empfängers, Figur 2 schematisch den Aufbau des eine Sendefrequenz kennzeichnenden Codes und Figur 3 einen Ablaufplan eines in der Steuerung 6 implementierten Programms.

### Beschreibung eines Ausführungsbeispiels

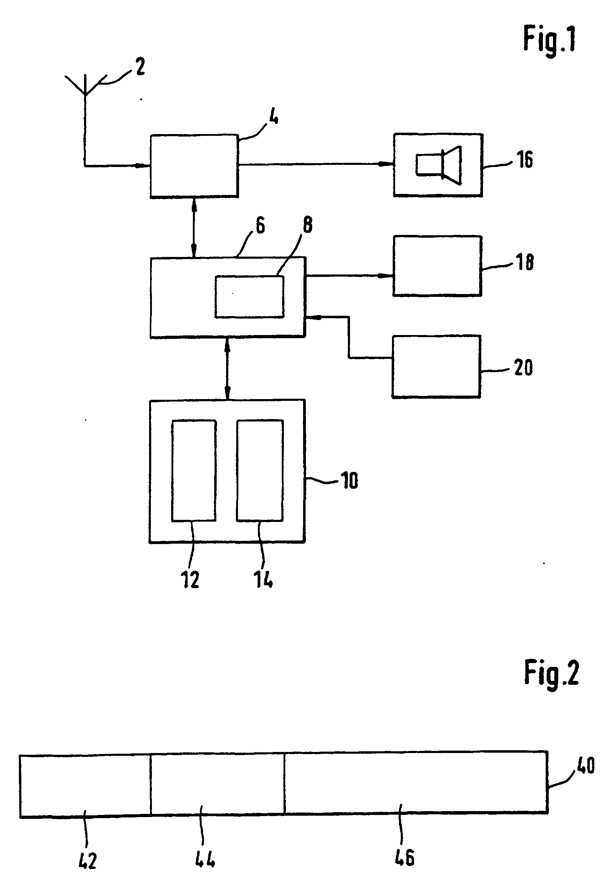

Ein Ausführungsbeispiel des erfindungsgemäßen Rundfunkempfängers ist in Figur 1 dargestellt. Ein Empfangsteil 4 ist an eine Empfangsantenne 2 angeschlossen und ausgangsseitig mit einer Wiedergabeeinrichtung 16 verbunden. Diese umfaßt in bekannter Weise die zur Wiedergabe des über das Empfangsteil 4 empfangenen Rundfunkprogramms erforderlichen Baugruppen, insbesondere Verstärker und Lautsprecher, wobei Einzelheiten der Wiedergabeeinrichtung 16 nicht in der Zeichnung dargestellt sind. Des weiteren ist das Empfangsteil 4 mit einer Steuerung 6 verbunden, die mit einer Ausgabeeinheit 18 und einer Eingabeeinheit 20 in Verbindung steht. Die Eingabeeinheit 20 verfügt neben den für die Bedienung des Rundfunkempfängers üblichen Bedienelementen, insbesondere Lautstärke- und Klangsteller, über eine nicht dargestellte "Blätter"-Taste, durch deren wiederholte Betätigung die auf den im Speicher abgelegten Sendefrequenzen übertragenen Programme sukzessive ausgewählt werden. Außerdem ist die Steuerung 6 mit einem Speicher 10 verbunden, der einen ersten Bereich 12 für Sendefrequenzen und einen zweiten Bereich 14 für die Sendefrequenzen kennzeichnende Codes, im vorliegenden Fall die PI-Codes des Radio-Daten-Systems enthält.

Der Aufbau des PI- (Programme Identifier-) Codes ist schematisch in Figur 2 dargestellt, wobei der erste Block 42 der Gruppe 40 die Länderkennung, der zweite Block 44 die Regionalkennung und der dritte Block 46 die Senderkennung darstellt. Die Länderkennung 42 dient der Codierung des Landes, in dem das jeweilige Programm ausgestrahlt wird, die Regionalkennung 44 gibt die räumliche Verbreitung des über die jeweilige Frequenz ausgestrahlten Programms an, während die Senderkennung 46 die Sendeanstalt und das jeweilige Programm kennzeichnet. Die Blöcke 42 und 44 umfassen dabei jeweils vier Bits, die Senderkennung 46 dagegen acht Bits.

Der PI-Code, der über das Radio-Daten-System ausgestrahlt wird, dient der Identifizierung eines auf einer Sendefrequenz ausgestrahlten Programmes. Dazu ist jedem Programm bzw. der jeweiligen zugehörigen Sendefrequenz ein individueller PI-Code zugeordnet. Vor allem bei größeren Sendeanstalten, z. B. dem Norddeutschen Rundfunk (NDR), werden Rundfunkprogramme, z. B. NDR 1, zu gewissen Tageszeiten (dynamisch) regionalisiert, so daß verschiedene Sender desselben Sendernetzes unterschiedliche Regionalprogramme, z. B. NDR 1 Harz, NDR 1 Hannover ..., ausstrahlen. Zur eindeutigen Unterscheidung ist jedem dieser Regionalprogramme ein eigener PI-Code zugeordnet, der in der Senderkennung 46 gleich ist und sich in der Regionalkennung 44 unterscheidet. Bei verschiedenen Programmketten wie z. B. NDR1 wird die Regionalisierung der PI-Codes auch dann aufrechterhalten, wenn die verschiedenen Regionalsender zu einem überregionalen Programm zusammengeschaltet werden (statische Regionalisierung).

Durch wiederholtes Betätigen der an der Bedieneinheit angebrachten Blättertaste ist nun der Benutzer des erfindungsgemäßen Rundfunkempfängers in der Lage, die auf den im Speicher abgelegten Sendefrequenzen übertragenen Programme sukzessive auszuwählen. Dazu wird auf Tastendruck jeweils die erste Sendefrequenz des auf das aktuell ausgewählte Programm im Speicher folgenden Programms ausgewählt, wobei die Programme im Speicher durch die PI-Codes repräsentiert werden. Dabei werden in einem zweiten Betriebszustand zur Unterscheidung von hinsichtlich ihres PI-Codes regionalisierten Programmen sowohl der Teilcode, also Länder- (42) und Senderkennung (46), als auch die Regionalkennung (44) herangezogen. Im Falle hinsichtlich ihrer PI-Codes statisch regionalisierter Programme, die gerade zu einem gemeinsamen überregionalen Programm zusammengeschlossen sind könnte diese Funktionsweise jedoch beim Benutzer unter Umständen den Eindruck einer Fehlfunktion erwecken, da nämlich in diesem Falle mehrfach ein Programm mit zwar unterschiedlichem PI-Code (unterschiedliche Regionalkennung (44), gleicher Teilcode (42, 46)), aber gleichem Programminhalt ausgewählt würde.

Zur Vermeidung dieses Verhaltens ist der erste Betriebszustand vorgesehen, bei dem nur der Teilcode (42, 46), nicht aber die Regionalkennung (44) ausgewertet wird. Durch Ignorieren der Regionalkennung (44) werden bei wiederholtem Betätigen der Blättertaste nur solche Programme ausgewählt, die sich im Teilcode (42, 46) unterscheiden, also im Falle von hinsichtlich des PI-Codes statisch regionalisierten Programmen nur jeweils das erste der im Speicher abgelegten "Regionalprogramme" einer Programmkette.

Dies soll anhand eines Beispiels verdeutlicht werden.

Der Speicherinhalt eines beispielsweise im norddeutschen Raum betriebenen Autoradios möge folgendermaßen aussehen:

| Land | Verbreitung | Programmname | Sendefrequenz |
|---|---|---|---|
| C (=GB) | GB | BBC1 | ... |
| D (=DE) | Raum Harz | NDR1(-Harz) | 98,0 |
| D | Raum Hannover | NDR1 (-Hannover) | 90,9 |
| D | Raum Hannover | NDR1(-Hannover) | 102,6 |
| D | Raum Lübeck | NDR1(-Lübeck) | ... |
| D | Nord-DE | NDR2 | ... |
| D | Nord-DE | NDR3 | ... |
| D | Süd-DE | SDR3 | 89,5 MHz |
| D | Süd-DE | SDR3 | 99,9 MHz |
| D | Südwest-DE | SWF3 | 98,4 MHz |
| D | Südwest-DE | SWF3 | 107,2 MHz |

Dabei stehen die ersten drei Spalten der Tabelle für den hier allerdings entschlüsselten PI-Code (Land = Länderkennung 42, Verbreitung = Regionalkennung 44, Programmname = Programmkennung 46). Die in Klammern gesetzten Ergänzungen sind dabei nicht Bestandteil des Codes.

Beim sukzessiven Aufrufen der im Speicher abgelegten Sendefrequenz im ersten Betriebszustand wird nach dem Programm BBC1 das im Speicher folgende Programm NDR1-Harz aufgerufen, da sich dieses im Teilcode (Länderkennung 42 (C -> D)) von dem Programm BBC1 unterscheidet. Bei erneutem Betätigen der Blättertaste wird das Programm NDR2 ausgewählt, und die übrigen NDR1-Programme werden übersprungen, da sich deren Teilcode 42, 46 nicht von dem des Programms NDR1-Harz unterscheidet. Das bedeutet, daß im Falle eines hinsichtlich seines PI-Codes statisch regionalisierten Programms nur das erste im Speicher abgelegte Regionalprogramm aufgerufen, die übrigen ignoriert werden.

Im zweiten Betriebszustand wird dagegen nach NDR1-Harz NDR1-Hannover und darauf NDR1-Lübeck ausgewählt, da die PI-Codes der drei Regionalprogramme zwar über den gleichen Teilcode, aber über unterscheidliche Regionalkennungen 44 verfügen, die im zweiten Betriebszustand berücksichtigt werden.

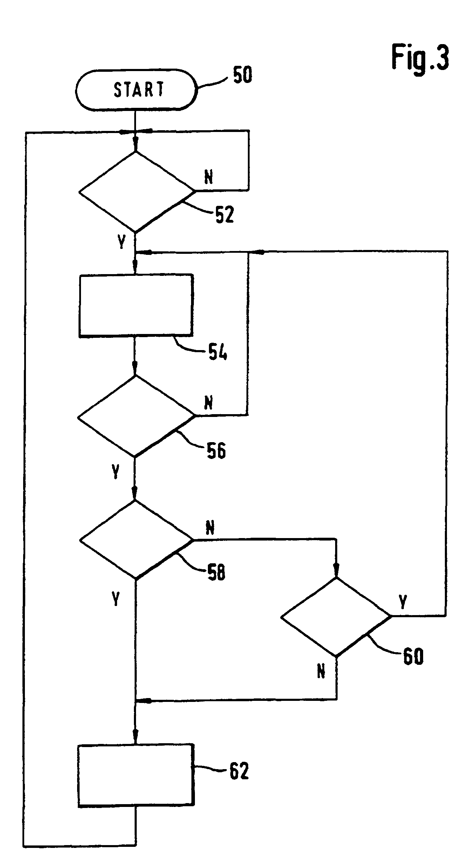

Die Funktionsweise des erfindungsgemäßen Empfängers wird anhand des in Figur 3 dargestellten Ablaufdiagramms erläutert. Das Programm startet beim Block 50. Wird an der Bedieneinheit 20 die Blättertaste betätigt, was in dem Block 52 abgefragt wird, so liest die Steuerung 6 im Block 54 aus dem Speicher 10 die Sendefrequenz aus, deren PI-Code im Speicher 10 auf den der aktuell ausgewählten Sendefrequenz folgt. Außerdem wird der zugehörige PI-Code ausgelesen. Sodann wird bei 56 überprüft, ob die ausgelesene Frequenz am aktuellen Empfängerstandort mit ausreichender Qualität zu empfangen ist. Ist dies nicht der Fall, geht die Steuerung zum Schritt 54 zurück und liest die nächste Sendefrequenz aus dem Speicher 10 aus. Ist die ausgelesene Frequenz am Empfängerstandort zu empfangen, so wird bei 58 geprüft, ob sich der Empfänger im ersten oder im zweiten Betriebszustand befindet, d. h. ob die Regionalkennung 44 des PI-Codes ausgewertet wird. Der Betriebszustand wird dabei über einen Schalter an der Bedieneinheit 20 vom Benutzer vorgegeben. Befindet sich der Empfänger im zweiten Betriebszustand, d. h. wird die Regionalkennung 44 zur Unterscheidung der Sendefrequenzen ausgewertet, so bedeutet dies, daß auch bei statisch regionalisierten PI-Codes bei 62 alle zugehörigen Programme sukzessive bei Betätigung der Blättertaste ausgewählt und akustisch wiedergegeben und/oder ihre Programmnamen angezeigt werden. Wird die Regionalkennung 44 nicht ausgewertet (1. Betriebszustand), so geht die Steuerung zum Punkt 60 über, wo geprüft wird, ob die Senderkennung des im Speicher auf das aktuell ausgewählte Programm folgenden Programms mit der des aktuell ausgewählten Programms übereinstimmt. Im positiven Fall liegt ein statisch regionalisierter PI-Code vor und die Steuerung kehrt ohne Auswahl der Sendefrequenz zum Punkt 54 zurück. Für den Fall, daß die Senderkennung der auf die aktuell ausgewählte Sendefrequenz folgenden Sendefrequenz sich von der Senderkennung der aktuellen Sendefrequenz unterscheidet, wird die im Speicher auf die aktuelle Sendefrequenz folgende Sendefrequenz bei 62 ausgewählt und akustisch und/optisch zur Anzeige gebracht.

Neben der Unterscheidung der Sendefrequenzen anhand der ihnen zugeordneten Codes gemäß der beschriebenen Ablaufsteuerung hat die Steuerung auch die Aufgabe, den Speicher (10) zu aktualisieren. Dazu werden zum einen die mit dem Radio-Daten-system als AF-Daten übertragenen Listen alternativer Frequenzen ausgewertet, zum anderen werden bei Durchfahren eines Gebiets die dort empfangbaren Sendefrequenzen und die zugehörigen PI-Codes in den Speicher eingeschrieben. Dabei wird davon ausgegangen, daß die Frequenzen in der Reihenfolge der ihnen zugeordneten PI-Codes sortiert im Speicher abgelegt werden, wobei die Länderkennung 42 das oberste, die Programmkennung 46 das nächstgeringere und die Regionalkennung 44 das geringstwertige Ordnungskriterium bilden.

Des weiteren ist es vorgesehen, daß bei Vorliegen mehrerer Sendefrequenzen mit gleichem PI-Code, d. h. mit gleicher Länder-, Regional- und Senderkennung, diese nach ihrer Empfangsqualität im Speicher abgelegt werden. Dies ist beispielhaft in der Tabelle am Beispiel der beiden Programme SWF3 und SDR3 dargestellt, die beispielsweise über jeweils zwei Sendefrequenzen verfügen.

Auf diese Weise werden im ersten Betriebszustand, in dem die Regionalkennung 44 nicht ausgewertet wird, von mehreren Regionalprogrammen mit dem gleichen Teilcode 42, 46, nur jeweils das am besten zu empfangende ausgewählt. Beim zweiten Betriebszustand bewirkt die Abspeicherung der Frequenzen in absteigender Folge der Empfangsqualität, daß von mehreren alternativen Frequenzen mit gleichem PI-Code, also desselben Programms (Beispiel SWF3, SDR3 in der Tabelle) nur die jeweils am besten zu empfangende Frequenz ausgewählt wird.

Beim Zurücklegen größerer wegstrecken oder beim Durchfahren ungünstigen, insbesondere bergigen Geländes würde eine Sortierung der Sendefrequenzen mit gleichem PI nach der Empfangsqualität häufige Überprüfungen der im Speicher abgelegten Sendefrequenzen auf ihre Empfangsqualität erfordern. Für diesen Fall ist eine Sortierung der Sendefrequenzen nach der Empfangsqualität unter Umständen nicht wünschenswert, da für die zahlreichen Qualitätsprüfungen zahlreiche Unterbrechungen des aktuell wiedergegebenen Programms erforderlich sind.

Um trotz fehlender Vorsortierung der Sendefrequenzen nach ihrer Empfangsqualität die Auswahl jeweils nur der am besten zu empfangenden Frequenz eines Programms zu ermöglichen, kann es vorgesehen sein, beim Betätigen der Blättertaste alle im Speicher abgelegten Frequenzen des jeweiligen Programms auszulesen, von den ausgelesenen Frequenzen die am besten zu empfangende Sendefrequenz zu bestimmen und diese auszuwählen. Im Falle der oben dargestellten Tabelle würden also im ersten Betriebszustand bei aktuell empfangenen Programm BBC1 bei einmaliger Betätigung der Blättertaste alle NDR1-Sendefrequenzen aus dem Speicher ausgelesen, die am besten zu empfangende dieser Frequenzen bestimmt und anschließend ausgewählt. Im zweiten Betriebszustand würden bei aktuell empfangenem Programm NDR1-Harz die beiden zu NDR1-Hannover verfügbaren Frequenzen ausgelesen, die am besten empfangbare der beiden Frequenzen ermittelt und ausgewählt. Somit können Überprüfungen der Sendefrequenzen auf ihre Empfangsqualtität auf die jeweils aktuell ausgewählte Frequenz und zeitlich auf die Dauer des "Programmblätterns" beschränkt werden.

Zur Verbesserung des Bedienungskomforts des erfindungsgemäßen Rundfunkempfängers kann es vorgesehen sein, das Empfangsteil 4 des Empfängers entweder für eine vorgegebene Zeit oder bis zum nächsten Betätigen der Blättertaste auf die ausgewählte Sendefrequenz abzustimmen und das auf der ausgewählten Frequenz übertragene Hörfunkprogramm über die Wiedergabeeinheit zu Gehör zu bringen. Zudem kann es vorgesehen sein, die ausgewählte Sendefrequenz über eine Ausgabeeinheit, im einfachsten Fall das Display des Radios, anzuzeigen. Weiterhin kann es vorgesehen sein, den Namen des auf der ausgewählten Sendefrequenz übertragenen Programms anzuzeigen, was durch Auswertung des der Sendefrequenz zugeordneten PI-Codes, welcher zusammen mit anderen Daten mit dem Radio-Daten-System neben dem eigentlichen Hörfunkprogramm übertragen wird, möglich ist.

## Patentansprüche

1. Rundfunkempfänger, insbesondere Autoradio, mit einem Speicher für Sendefrequenzen und für die auf den Sendefrequenzen übertragene Programme kennzeichnenden Codes, welche einen Teilcode, bestehend aus einer Länderkennung (42) zur Kennzeichnung des Landes, in dem das Programm ausgestrahlt wird und einer Programmkennung (46), sowie eine Regionalkennung (44) zur Kennzeichnung der räumlichen Verbreitung des über die Sendefrequenz übertragenen Programms aufweisen,
wobei die Sendefrequenzen sortiert nach den sie kennzeichnenden Codes im Speicher abgelegt sind,
und wobei eine Einrichtung (8) zur Unterscheidung der Codes vorgesehen ist,
**dadurch gekennzeichnet,**
**daß** auf ein Steuersignal die Sendefrequenz des Programms auswählbar ist, dessen Code im Speicher auf den des aktuell ausgewählten Programms folgt,
**daß** in einem ersten Betriebszustand nur die Sendefrequenzen auswählbar sind, deren zugeordnete Codes sich in dem Teilcode (42, 46) von dem aktuell eingestellten Sender unterscheiden,
und **daß** in einem zweiten Betriebszustand Sendefrequenzen auswählbar sind, deren zugeordnete Codes sich in dem Teilcode (42, 46) und/oder der Regionalkennung (44) von der aktuell ausgewählten Sendefrequenz unterscheiden.

2. Rundfunkempfänger nach Anspruch 1,
**dadurch gekennzeichnet,**
**daß** nur die am Empfängerstandort tatsächlich empfangbaren Sendefrequenzen auswählbar sind.

3. Rundfunkempfänger nach Anspruch 1 oder 2,
**dadurch gekennzeichnet,**
**daß** bei Vorliegen mehrerer Sendefrequenzen mit gleichem Teilcode (42, 46) und unterschiedlicher Regionalkennung (44) nur die am besten zu empfangende Sendefrequenz mit der entsprechenden Programmkennung (42, 46) auswählbar ist.

4. Rundfunkempfänger nach einem der Ansprüche 1 bis 3,
**dadurch gekennzeichnet,**
**daß** die ausgewählte Sendefrequenz am Empfangsteil (4) eingestellt und das auf der Sendefrequenz übertragene Programm für eine vorgegebene Zeitdauer wiedergebbar ist.

5. Rundfunkempfänger nach einem der Ansprüche 1 bis 4,
**dadurch gekennzeichnet,**
**daß** die ausgewählte Sendefrequenz und/oder der Name des auf der Sendefrequenz übertragenen Programms über eine optische Anzeigeeinheit (18) anzeigbar ist.

6. Rundfunkempfänger nach einem der Ansprüche 1 bis 5, **gekennzeichnet durch** Mittel zum Auslesen der die Sendefrequenzen kennzeichnenden Codes aus neben den Programmen auf den Sendefrequenzen übertragenen Codes des Radio-Daten-Systems.

## Claims

1. Broadcast radio receiver, particularly a car radio, having a memory for transmission frequencies and for codes which identify the programmes transmitted on the transmission frequencies and which have a subcode, comprising a country identifier (42) for identifying the country in which the programme is being broadcast and a programme identifier (46), and also a regional identifier (44) for identifying the spatial distribution of the programme transmitted using the transmission frequency,
where the transmission frequencies are stored in the memory in a form sorted according to the codes which identify them,
and where a device (8) for distinguishing the codes is provided,
**characterized**
**in that** upon a control signal it is possible to select the transmission frequency of the programme whose code in the memory follows that of the currently selected programme,
**in that** in a first operating state it is possible to select only the transmission frequencies whose associated codes differ in the subcode (42, 46) from the currently set station,
and **in that** in a second operating state it is possible to select transmission frequencies whose associated codes differ in the subcode (42, 46) and/or the regional identifier (44) from the currently selected transmission frequency.

2. Broadcast radio receiver according to Claim 1,
**characterized**
**in that** only the transmission frequencies which can actually be received at the receiver location can be selected.

3. Broadcast radio receiver according to Claim 1 or 2,
**characterized**
**in that** when there are a plurality of transmission frequencies with the same subcode (42, 46) and different regional identifiers (44) it is possible to select only the transmission frequency with best reception with the corresponding programme identifier (42, 46).

4. Broadcast radio receiver according to one of Claims 1 to 3,
**characterized**
**in that** the selected transmission frequency is set on the reception part (4), and the programme transmitted on the transmission frequency can be reproduced for a prescribed period.

5. Broadcast radio receiver according to one of Claims 1 to 4,
**characterized**
**in that** the selected transmission frequency and/or the name of the programme transmitted on the transmission frequency can be displayed using a visual display unit (18).

6. Broadcast radio receiver according to one of Claims 1 to 5,
**characterized by** means for reading the codes identifying the transmission frequencies from codes in the radio data system which are transmitted on the transmission frequencies besides the programmes.

## Revendications

1. Récepteur radio, en particulier autoradio, comprenant une mémoire pour des fréquences d'émission, et pour des codes définissant des programmes transmis sur les fréquences d'émission et qui présentent un code partiel, composé d'un identifiant national (42) pour définir le pays dans lequel le programme est émis et d'un identifiant de programme (46), ainsi que d'un identifiant régional (44) pour définir la diffusion spatiale du programme transmis par l'intermédiaire de la fréquence d'émission,
les fréquences d'émission triées suivant les codes qui définissent celles-ci étant déposées dans la mémoire, et un dispositif (8) de différenciation des codes étant prévu,
**caractérisé en ce que**
la fréquence d'émission du programme est sélectionnée sur un signal de commande dont le code dans la mémoire suit celui du programme actuellement sélectionné,
un premier état de fonctionnement, ne permet que la sélection des fréquences d'émission dont les codes associés se distinguent, dans le code partiel (42, 46), de l'émetteur effectivement réglé,
et un second état de fonctionnement, ne permet que la sélection des fréquences d'émission dont les codes associés se distinguent, dans le code partiel (42, 46) et/ou l'identifiant régional (44), de la fréquence d'émission effectivement sélectionnée.

2. Récepteur radio selon la revendication 1,
**caractérisé en ce que**
seules les fréquences d'émission réellement reçues sur le site de réception peuvent être sélectionnées.

3. Récepteur radio selon la revendication 1 ou 2,
**caractérisé en ce que**
en présence de plusieurs fréquences d'émission comportant le même code partiel (42, 46) et un identifiant régional (44) différent, seule la fréquence d'émission pouvant être la mieux reçue avec l'identifiant de programme (42, 46) correspondant peut être sélectionnée.

4. Récepteur radio selon l'une des revendications 1 à 3,
**caractérisé en ce que**
la fréquence d'émission sélectionnée est réglée au niveau de l'élément de réception (4), et le programme transmis sur la fréquence d'émission est reproduit pour une durée prédéterminée.

5. Récepteur radio selon l'une des revendications 1 à 4,
**caractérisé en ce que**
la fréquence d'émission sélectionnée et/ou le nom du programme transmis sur la fréquence d'émission sont affichés sur une unité d'affichage optique (18).

6. Récepteur radio selon l'une des revendications 1 à 5,
**caractérisé par**
des moyens de lecture du code qualifiant les fréquences d'émission à partir de codes du système de radiocommunication de données transmis sur les fréquences d'émission en plus des programmes.
